# EUROPEAN PATENT APPLICATION

(11) **EP 1 703 554 A2**
(43) Date of publication of application: **20.09.2006**
(21) Application number: 06002391.8
(22) Date of filing: 06.02.2006
(51) Int. Cl.: H01L 23/049, H01L 25/07

(54) **Power semiconductor module**

(30) Priority: 14.03.2005 JP 2005070255
(71) Applicant: HITACHI, LTD., Chiyoda-ku Tokyo 100-8280 (JP)
(72) Inventor: Koike, Yoshihiko, 1-chome, Chiyoda-ku, Tokyo 100-8220 (JP); Toyoda, Yasushi, 1-chome, Chiyoda-ku, Tokyo 100-8220 (JP); Saito, Katsuaki, 1-chome, Chiyoda-ku, Tokyo 100-8220 (JP)
(74) Representative: Strehl Schübel-Hopf & Partner

(57) **Abstract**

Power semiconductor equipment according to the present invention reduces the stress applied to a joint part (117) by reducing the thickness (t2,t3) of a portion of a terminal (110,403) at which the terminal is joined to a metallic circuit (104) on an insulated substrate (103) below the thickness (t1,t4) of another portion of the terminal (110,403) through which the main current flows or by dividing the portion (117) of the terminal (110,403) at which the terminal is joined to the metallic circuit (104) on the insulated substrate (103) with a slit (202). The power semiconductor equipment according to the present invention improves the reliability of the solder connected part (117), and reduces the resistance and inductance of a wire in the module because the wire can be shortened.

Thereby, the reliability of a solder part that connects a terminal in power semiconductor equipment to a circuit on an insulated substrate can be increased.

## Description

### FIELD OF THE INVENTION

The present invention relates to power semiconductor equipment and, more particularly, to the module structure of high-withstand voltage power semiconductor equipment that has achieved a large capacity and high reliability.

### BACKGROUND OF THE INVENTION

One known type of conventional power semiconductor equipment is structured by hermetically sealing power semiconductor devices such as insulated-gate bipolar transistors (IGBTs), diodes, gate turn-off (GTO) thyristors, and power metal oxide semiconductor field-effect transistors (MOSFETs) in an insulated container. These devices are used in various types of inverters and other apparatus according to the withstand voltage and current capacity. Particularly, the IGBT device is a voltage-controlled device and therefore has advantages in that, for example, control is performed easily and high frequency operation with high current is possible. In many cases, since a metallic substrate at the bottom of the module and a current-carrying part are electrically isolated from each other in the module, mounting in the inverter is simplified, which has been rapidly widening the range of applications.

In the basic structure of the equipment described above, semiconductor devices are mounted on the insulated substrate in the module; the number of semiconductor devices to be connected in parallel in the module is increased according to the current capacity. The devices connected in parallel in the module are connected to the outside of the module through metallic terminals. The terminals and a plastic package are bonded to assure the internal hermeticity of the module. Accordingly, the module suffers from expansion and contraction during operation; this may also happen at some ambient temperatures during storage. At this time, the terminals connected to the module also move in response to the expansion or contraction, and stress is applied to the joint part. As a result, the stress deteriorates the joint part.

In a conventional method of reducing the stress, the stress at the joint part of the terminal is reduced by forming part of the terminal in an S or horseshoe shape to accommodate the deformation, as described in Japanese patent laid-open No. Sho 62(1987)-104058. When the internal hermeticity of the module is not needed, another structure is used, in which the terminals and the plastic part are not bonded so that the terminals and case can deform independently of each other, which reduces the stress applied to the terminals and thereby assures the life of the joint part.

### SUMMARY OF THE INVENTION

The prior art described above has a problem described below. When higher current is required for the module, the number of chips to be connected in parallel in the module needs to be increased, increasing the size of the module. This enlarges the module deformation due to thermal stress. When the conventional method in which the terminal is deformed is used to reduce the stress that is applied to the joint part of the terminal when a large module is employed, the S shape has to be made large. This drops the voltage at the terminal and increases the internal inductance of the terminal.

As the current becomes higher, the terminal is thickened or widened to suppress the heat generated by the terminal itself due to the current that passes through the terminal. In either case, the S shape has to be made large and a similar problem arises.

An object of the present invention is to provide - power semiconductor equipment that increases the reliability of a solder part that interconnects a terminal and a circuit on an insulated substrate.

Power semiconductor equipment according to the present invention reduces stress applied to a joint part by reducing the thickness of a portion of a terminal that is joined to a metallic circuit on an insulated substrate below the thickness of another portion of the terminal through which the main current passes or by making a slit to divide the portion of the terminal that is connected to the metallic circuit on the insulated substrate.

The present invention increases the reliability of a solder connection, reduces the resistance and inductance of the wiring in an IGBT module, and downsizes the module.

### BRIEF DESCRIPTION OF THE DRAWINGS

FIG. 1 is a cross-sectional view of the present invention.
FIG. 2 shows the inventive terminal part in detail.
FIG. 3 shows the relation between the length of the bend of the inventive terminal part and the solder stress.
Fig. 4 is a cross-sectional view of the wiring between the inventive chip and substrate.

### DESCRIPTION OF THE PREFERRED EMBODIMENTS

The invention of the present application will be described below in detail with reference to the drawings.

### Embodiment 1:

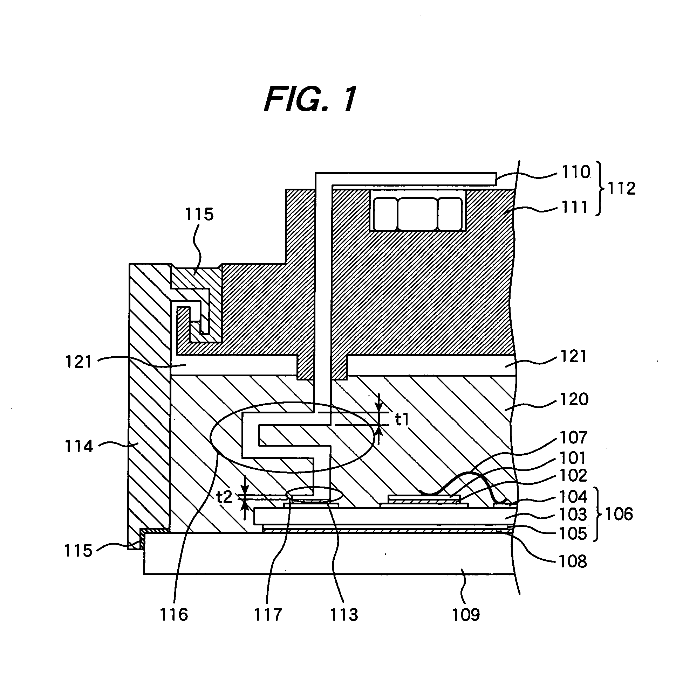

FIG. 1 is a cross-sectional view of part of an IGBT module (hereinafter abbreviated as a module) of this embodiment. Reference numeral 101 in FIG. 1 indicates a silicon semiconductor device such as an IGBT chip, which is a semiconductor switching device, or a free wheeling diode chip; the main current flows in the thickness direction of the silicon chip. Reference numeral 106 indicates an insulated circuit substrate that is formed by mounting metallic foil circuits 104 and 105 on the front and back surfaces of an insulated substrate 103 comprising aluminum nitride (A1N), alumina, and other ceramics. Reference numeral 102 indicates a solder layer below the chip, 107 indicates an aluminum wire, 108 indicates another solder layer below the insulated substrate, 109 indicates a metallic base, 110 indicates a terminal, 111 indicates a terminal block resin member, 112 indicates a terminal block, 113 indicates another solder layer below the terminal, 114 indicates a plastic case, 115 indicates an adhesive, 116 indicates an S-shaped stress relaxation part of the terminal, 117 indicates a connection part at which the terminal is soldered, 120 indicates a silicone gel, and 121 indicates a spacing formed between the silicone gel and terminal block resin member.

The procedure for manufacturing the module according to this embodiment will be briefly described below. To assure the internal insulation of the module, the semiconductor device 101 is joined on the insulated circuit substrate 106 through the solder layer 102. When the current capacity of the module is large, a plurality of semiconductor devices 101 are mounted on the same insulated circuit substrate 106 and connected in parallel by using aluminum wires 107; alternatively, a plurality of insulated circuit substrates 106 are provided in parallel in the module and connected. The insulated circuit substrate 106 on which the semiconductor device 101 is mounted through the solder layer 107 to the metallic base 109, which is made of a composite material comprising, for example, oxygen-free copper, a copper alloy, aluminum silicon carbide (Al-SiC), and Copper Molybdenum (Cu-Mo).

The terminal block 112, which is formed by integrating the terminal 110 with the terminal block resin member 111 that constitutes a lid, is set as a terminal for an external retrieval from the circuit in the module; the terminal 110 is joined to the insulated circuit substrate 106 through the solder layer 113. Usually used as the terminal 110 having this type of construction is a metallic conductive plate with low electrical resistance and high thermal conductivity that is made of, for example, nickel-plated oxygen free copper or a copper alloy.

Then, the plastic case 114, which forms the outer periphery of the module, is joined to the metallic base 109 with the adhesive 115. To assure insulation among the semiconductor device 101, aluminum wire 107, and terminal 110 in the module, the silicone gel 120 is supplied. The spacing 121 is provided in the upper part in the module in order to accommodate the thermal expansion of the silicone gel 120 in the module. Finally, the joint part between the terminal block resin member 111 and plastic case 114 is sealed by the adhesive 115 to assure the internal hermeticity of the module. This produces a complete module.

In the module according to this embodiment, to assure the internal hermeticity of the module, the terminal 110 is integrated with the terminal block resin member 111, forming the terminal block 112. Therefore, the expansion and contraction due to the thermal stress to the module apply horizontal and vertical deforming forces to the solder layer 113 between the terminal 110 and insulated circuit substrate 106. At this time, the S-shaped stress relaxation part 116 formed as part of the terminal 110 deforms to accommodate the displacement and thereby reduces the stress applied to the solder layer 113 that joins the terminal 110 to the insulated circuit substrate 106.

Furthermore, since the thickness t2 of the terminal's solder connected part 117 is smaller than the thickness t1 of the another portion of the terminal 110, the stress applied to the solder layer 113 due to the thermal deformation of the terminal 110 can be reduced. This shape of the terminal's solder connected part 117 in this embodiment can be formed easily when a metal press working process is added for the terminal 110 before the terminal 110 is integrated into the terminal block resin member 111.

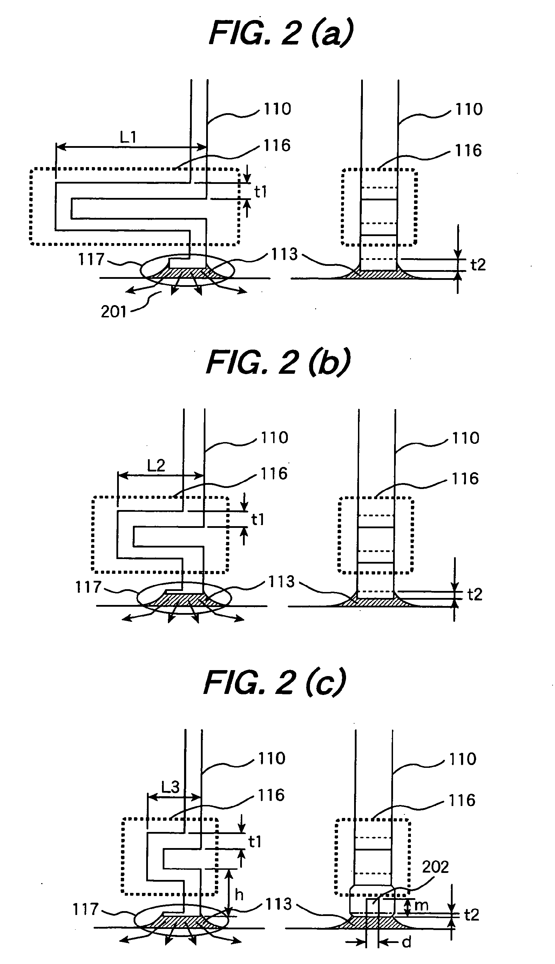

FIG. 2 shows the terminal's solder connected part 117 in detail. FIG. 2 (a) shows a prior art structure for comparison purposes. In the prior art structure in FIG. 2 (a), the thickness t1 of the terminal 110 at the terminal's solder connected part 117 is the same as the thickness of another portion (the S-shaped stress relaxation part 116, for example) of the terminal 110, so the length L1 of the S-shaped stress relaxation part 116 is sufficiently prolonged to reduce the stress to the solder layer 113.

In this embodiment shown in FIG. 2 (b), however, the thickness t2 of the terminal 110 at the terminal's solder connected part 117 is smaller than the thickness t1 of another portion (the S-shaped stress relaxation part 116, for example) of the terminal 110, which reduces the stress generated due to the difference in the linear thermal expansion coefficient between the terminal 110 itself and the insulated circuit substrate 106. Accordingly, the length of the S-shaped stress relaxation part 116, which is required to assure the same level of reliability against the thermal stress, can be reduced down to L2.

If the thickness t2 of the terminal 110 at the terminal's solder connected part 117 is 80 % to 20 %, preferably 65 % to 35 %, of the thickness t1 of the other portion of the terminal 110, an effect of reducing the stress due to the expansion and contraction of the terminal 110 itself is obtained. If the thickness t2 of the terminal 110 exceeds 80 % of the thickness t1 of the other portion of the terminal 110, the effect of reducing the stress becomes small. However, a thickness of less than 20 % of the thickness t1 of the other portion of the terminal 110 is not preferable because heat is generated due to the concentration of current and the mechanical strength is reduced.

The thickness t2 of the terminal 110 at the terminal's solder connected part 117 may be smaller than the length of the shorter side of an approximate rectangle at the joint part at which the terminal 110 is joined to the insulated circuit substrate 106.

If the thickness t2 of the terminal at the terminal's solder connected part 117 is small, this embodiment does not cause abnormal heat generation due to the concentration of current because the main current 201 spreads in the transversal direction on the insulated circuit substrate 106.

FIG. 2 (c) shows another form of this embodiment. It differs from FIG. 2 (b) in that the thickness of the terminal's solder connected part 117 is reduced and a slit 202 with a width of "d" is formed in the terminal's solder connected part 117, as shown in FIG. 2 (c). Since the slit 202 is formed, solder in the solder layer 113 enters the slit by capillary action. The solder in the slit 202 accommodates the stress, which would otherwise increase as the joining area enlarges, as seen in a module with a large current capacity. Accordingly, the length of the S-shaped stress relaxation part 116, which is required to assure the same level of reliability against the thermal stress, can be further reduced down to L3. The use of the structure shown in FIG. 2 (c) also reduces the terminal resistance and terminal inductance which are proportional to the total length of the terminal.

The slit 202 shown in FIG. 2 (c) may be a single slit or a plurality of slits. Due to restrictions on the mechanical strength of the solder and solder connected part 117, however, at most five slits may be provided; one to three slits are sufficient. It is desirable that the length "m" of the slit shown in FIG. 2 (c) be 80 % or less, preferably 75 % or less, of the height "h" shown in FIG. 2 (c); if 80 % is exceeded, the slit is not completely filled with solder, in which case less stress is accommodated and the mechanical strength is reduced.

The end of the terminal 110 may be open or closed at the slit 202. The slit 202 may have a continuous shape or may be blocked by a tie bar in the middle.

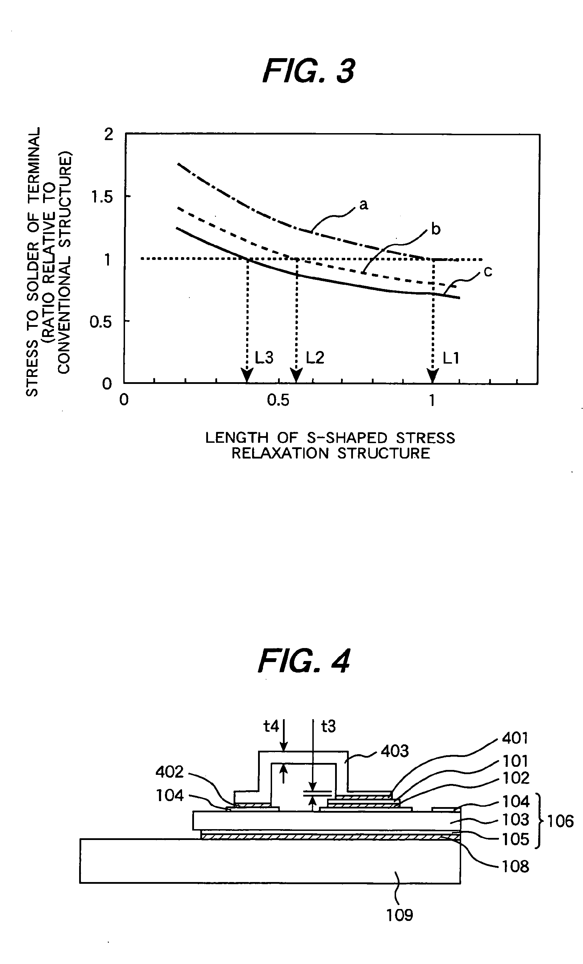

FIG. 3 shows an analysis result of the relation between the length of the S-shaped stress relaxation part and the stress to the solder connected part. The graph "a" in FIG. 3 shows the stress applied to the solder layer 113 when the length of the S-shaped stress relaxation part 116 is L1 and the thickness of the terminal 110 is constant at t1. In the graph "b" in FIG. 3 in which the thickness t2 of the solder connected part 117 is halved, assuming that the stress is 1, the stress to the solder layer 113 is reduced to about 80 % if the length of the S-shaped stress relaxation part 116 is the same. When the slit 202 shown in FIG. 2 (c) is added to the solder connected part 117, the stress can be further reduced by 10 %.

Assuming that the stress applied to the solder layer 113 is 1 when the length of the S-shaped stress relaxation part 116 is L1 and the thickness of the terminal 110 is constant at t1, as indicated by graph "a" in FIG. 3, the stress becomes 1 at the length L2 which is 56 % of L1, as indicated by the graph "b" in FIG. 3 in which the thickness t2 of the solder connected part 117 is halved. Similarly, when the slit 202 is added, the stress becomes 1 at the length L3 which is 40 % of L1, as indicated by the graph "c" in FIG. 3.

These structures used in this embodiment enable the reduction of the length L1 of the S-shaped stress relaxation part 116, which is needed to restrict the stress at the solder joint part within a certain allowable range, and of the spacing occupied in the module. In addition, the degree of freedom for the shape of the terminal in the module and the aluminum wire layout is increased. Therefore, circuitry having a plurality of electric potentials can be formed easily in a single module.

### Embodiment 2:

FIG. 4 shows this embodiment. In FIG. 4, the present invention is applied to the wiring in a module. The embodiment differs from embodiment 1 in FIG. 1 in that the semiconductor device 101 and the metallic foil circuit 104 on the insulated substrate 103 are interconnected by a metallic terminal 403 instead of the aluminum wire 107 in embodiment 1. The use of a metallic wiring circuit, in which the metallic terminal 403 is used, enables the area of the connection part to be widened compared when the aluminum wire 107 is used, which furthermore improves the reliability of the joint part. Nickel-plated oxygen-free copper, tough pitch copper, or another material with low electric resistance and large thermal conductivity is used for the metallic terminal 403. The semiconductor device 101 and metallic terminal 403 are joined to each other through solder layers 401 and 402. The thickness t3 on the side of the semiconductor device 101 (α = 3 × 10⁻⁶/ºC) having a large difference in the thermal expansion coefficient from the thermal expansion coefficient (α = 17 × 10⁻⁶/ºC) of the oxygen free copper of the metallic terminal 403 is smaller than the thickness t4 shown in FIG. 4 to improve the reliability. In FIG. 4, the side of only the semiconductor device 101 is thinned, but the portion connected to the metallic foil circuit 104 through the solder layer 402 may also be thinned.

In this embodiment as well, a slit as in embodiment 1 may be formed in the joint part between the metallic terminal 403 and semiconductor device 101 or another joint part between the metallic terminal 403 and metallic foil circuit 104.

## Claims

1. Internally insulated power semiconductor equipment that has a metallic substrate (109) at the bottom, the side surface and top surface being enclosed by an organic resin member (114,111), a plurality of power semiconductor devices (101) being mounted therein, an insulated circuit substrate (106) being provided between the metallic substrate at the bottom and the plurality of power semiconductor devices, one end of a metallic conductor plate (110) being bent and connected to the insulated circuit substrate through a joining member (113), wherein:
the metallic conductor plate (110) is a metallic terminal another end of which is connected to an external conductor; a stress relaxation part (116) having a plurality of bends is provided between the one end and the other end; the thickness (t2) of the one end connected to the insulated circuit substrate (106) is smaller than the thickness (t1) of the stress relaxation part.

2. The power semiconductor equipment according to claim 1, wherein a terminal surface of the one end, at which the metallic conductor plate is bent, forms a rectangle; the thickness of the one end is smaller than the length of the shorter side of the rectangle.

3. The power semiconductor equipment according to claim 1, wherein a member between the other end of the metallic conductor plate and the stress relaxation part is formed integrally with the resin member that encloses the top surface; the power semiconductor device is an IGBT.

4. The power semiconductor equipment according to claim 3, wherein the one end connected to the insulated circuit substrate is thinned by press working.

5. Internally insulated power semiconductor equipment that has a metallic substrate at the bottom, the side surface and top surface being enclosed by an organic resin member, a plurality of power semiconductor devices being mounted therein, an insulated circuit substrate being provided between the metallic substrate at the bottom and the plurality of power semiconductor devices, one end of a metallic conductor plate being bent and connected to the insulated circuit substrate through a joining member, wherein:
the metallic conductor plate is a metallic terminal another end of which is connected to an external conductor; a stress relaxation part having a plurality of bends is provided between the one end and the other end; the one end connected to the insulated circuit substrate is divided by a slit part.

6. The power semiconductor equipment according to claim 5, wherein the thickness of the one end of the metallic conductor plate is smaller than the thickness of the stress relaxation part.

7. The power semiconductor equipment according to claim 5, wherein there is an opening of the slit part at the one end of the metallic conductor plate.

8. The power semiconductor equipment according to claim 5, wherein the slit part also extends between the one end of the metallic conductor plate and the stress relaxation part having the bends.

9. The power semiconductor equipment according to claim 6, wherein a member between the other end of the metallic conductor plate and the stress relaxation part is formed integrally with the resin member that encloses the top surface; the power semiconductor device is an IGBT.

10. Internally insulated power semiconductor equipment that has a metallic substrate (109) at the bottom, the side surface and top surface being enclosed by an organic resin member (114,111), a plurality of power semiconductor devices (101) being mounted therein, an insulated circuit substrate (106) being provided between the metallic substrate at the bottom and the plurality of power semiconductor devices, one end of a metallic conductor plate (403) being bent and connected to the insulated circuit substrate through a joining member (402), another end of the metallic conductor part being bent and connected to one of the power semiconductor devices (101) through another joining member (401), wherein:
the thickness (t3) of the other end of the metallic conductor plate (403) connected to the power semiconductor device (101) is smaller than the thickness (t4) of a member between the bend at the one end and the bend at the other end.

11. The power semiconductor equipment according to claim 10, wherein the other end connected to one of the power semiconductor devices is divided by a slit part.

12. The power semiconductor equipment according to claim 11, wherein there is an opening of the slit part at the one end of the metallic conductor plate.
